# EUROPEAN PATENT APPLICATION

(11) **EP 0 607 820 A2**
(43) Date of publication of application: **27.07.1994**
(21) Application number: 94100189.3
(22) Date of filing: 07.01.1994
(51) Int. Cl.: H01L 21/28, H01L 21/285

(54) **Method for producing semiconductor device having metal silicide layer on diffusion region**

(30) Priority: 08.01.1993 JP 1480/93
(71) Applicant: NEC CORPORATION, Tokyo (JP)
(72) Inventor: Ooka, Hideyuki, c/o NEC Corporation, Minato-ku, Tokyo (JP)
(74) Representative: Glawe, Delfs, Moll & Partner

(57) **Abstract**

A method of producing a semiconductor device disclosed herein comprises the steps of forming a metal silicide layer at the surface of an element region, forming an insulating film over the entire surface, forming a contact hole in the insulating film to expose part of the metal silicide layer, implanting impurity ions through the contact hole and the metal silicide layer to form an impurity-ion-implanted region before or after forming a refractory metal in the contact hole, and annealing in an atmosphere free from oxygen to activate the impurity ions contained in the impurity-ion-implanted region after forming the refractory metal.

## Description

### BACKGROUND OF THE INVENTION

This invention relates to a method for producing a semiconductor device and, more particularly, to method of forming a wiring layer in contact with a metal silicide layer formed on a surface of a diffusion region.

Recently, it has been required to increase the integration density and performance of a semiconductor integrated circuit device without lowering the switching speed of each MOS transistor. For this purpose, it has been proposed and put into practical use to replace a conventional transistor structure in which an aluminium wiring layer in direct-contact with a diffused region such as a source and a drain by an improved transistor structure in which a metal silicide layer such as a titanium silicide layer is inserted between the surface of the diffused region and the aluminium wiring layer. Such a transistor thereby has a reduced sheet resistance with respect to the source and drain regions thereof even if those regions are formed in a fine pattern. The fine pattern of each region causes to reduce a stray capacitance thereof. The transistor thus produced operates at a higher speed.

In order to enhance the integration density, further, it is attained to reduce the so-called alignment margin between each diffusion region and an associated contact hole. In other words, each contact hole is formed in an interlayer insulating film to be allowed to expose a part of a PN junction between the associated diffusion region and a substrated in which the region is formed. In order to prevent a short circuit of the PN junction by a wiring layer for the diffusion region, however, impurity ions having the same conductivity as the diffusion region is introduced through the contact hole before forming the wiring layer. The surface portion exposed by the contact hole is converted into a region having the same conductivity type as the diffusion region.

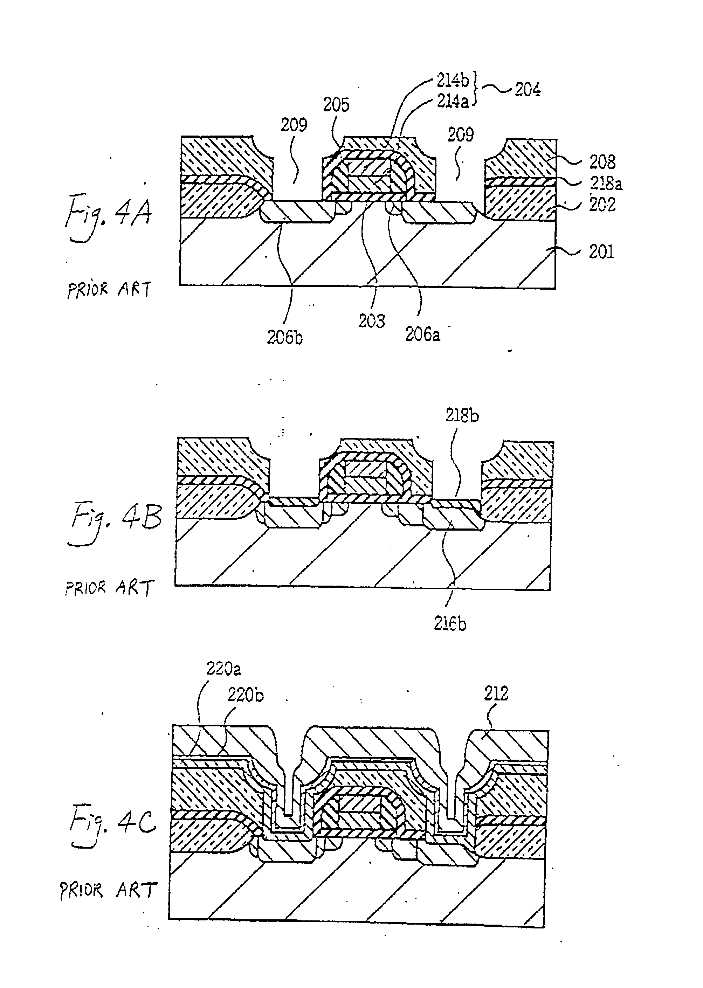

The method for reducing the alignment margin will be further, described in detail below with reference to Fig. 4.

Referring to Fig. 4A, a field oxide fiom 202 is selectively formed on the surface of an n-type silicon substrate 201 to isolate an active region. In this active region, the so-called lightly-doped-drain (LDD) MOS transistor is formed, which has a gate oxide film 203, a gate electrode 204 consisting of a polysilicon film 214a and a tungsten silicide film 214b, low or lightly doped regions 206a of a p-type, and a high doped regions 206b of the p-type. Formed on the side surfaces of the gate electrode 204 are side wall spacers 205. Thereafter, an interlayer insulating film consisting of a silicon oxide film 218a and a borophosphosi- licate grass (BPSG) film 208 are deposited by the chemical vapor deposition (CVD) technique are formed over the entire surface, followed by selectively forming contact holes 209. As shown in Fig. 4A, in this case, the alignment margin is made small, so that the right-hand contact hole 209 exposes a part of a PN junction between the substrate 201, and the region 206b. For this reason, if a wiring layer would be formed successively, a short circuit would take place between the region 206b and the substrate 201. In order to solve this drawback, therefore, p-type impurities are introduced into the substrate.

To this end, as shown in Fig. 4B, a silicon oxide film 218b is formed by thermal oxidation or the CVD technique on the surface portions of the silicon substrate 201 surface (including the surface of p⁺ layer 206b) exposed by the contact holes 209. Thereafter, p-type impurity ions are implanted through the film 218b, followed by heat treatment to activate the implanted ions. P-type regions 216b are thereby formed. The silicon oxide film 218b is required to prevent phosphorus out-diffused from the BPSG film 208 from being doped into the regions 206b during the heat treatment.

The silicon oxide film 218b is thereafter removed. A titanium film 220a, a titanium nitride film 220b, and an aluminium film 212 are then deposited in that order by the sputtering technique over the entire surface, a shown in Fig. 4C. By patterning these metal films, a desired wiring pattern is derived. The titanium film 220a and the titanium nitride film 220b serve as barrier layers for preventing the formation of the so-called alloy spike caused by the abnormal diffusion between the aluminium film 212 and the regions 216b.

Thus, the required alignment margin is reduced. Accordingly, to produce a semiconductor device of a high integration density without lowering the switching speed of each transistor, it is preferable to combine a metal silicon technique with a alignment margin reduction technique.

However, a metal silicide layer formed on the diffusion regions 206 is also oxidized by the thermal oxidation process for forming the silicon oxide films 218b. For this reason, the resistance of the silicide layer is made high remarkably, so that the contact resistance is increased to lower the switching speed of the transistor.

It is therefore considered to form the silicon oxide film 218b by the low-temperature CVD techniaue and to anneal in an inert gas atmosphere to form the regions 216b. In this case, however, an etchant such as a fluoric acid for removing the silicon oxide film 218b also removes the metal silicide layer. As a result, the metal silicide layer disappears at a contact portion between the regions 216b and the wiring layers, so that the contact resistance is enhanced to lower the switching speed of the transistor.

### SUMMARY OF THE INVENTION

It is therefore a major object of the present invention to provide a method of producing a semiconductor device in which an alignment margin reduction technique is applied to a metal silicide technique.

A method according to the present invention comprises the steps of selectively forming in a semiconductor substrate of one conductivity type a plurality of elerent regions of an opposite conductivity type each having a metal silicide layer formed on a part thereof, forming an interlayer insulating film over an entire surface, forming a plurality of contact holes each exposing at least one part of the metal silicide layer of an associated one of the element regions, i m-planting impurity ions representive of the opposite conductivity type through the contact holes as mask, forming a high melting point or a refractory metal film over an entire surface before or after implanting the impurity ions, and carrying out a heat treatment to activate the implanted impurity ions at an atmosphere free from oxygen.

### BRIEF DESCRIPTION OF THE DRAWINGS

The above-mentioned and other objects, features and advantages of this invention will become more apparent from the following detailed description taken in conjunction with the accompanying drawings, wherein:
Fig. 1A to Fig. 1E are cross-sectional views for illustrating a sequence of fabrication steps according to a first embodiment of the present invention;
Fig. 2A to Fig. 2C are cross-sectional views for illustrating a sequence of fabrication steps according to a second embodiment of the present invention;
Fig. 3 is a cross-section view for illustrating one of a sequence of fabrication steps according to a third embodiment of the present invention; and
Fig. 4A to Fig. 4C are cross-sectional views for illustrating a sequence of fabrication steps according to the prior art.

### DESCRIPTION OF THE PREFERRED EMBODIMENTS

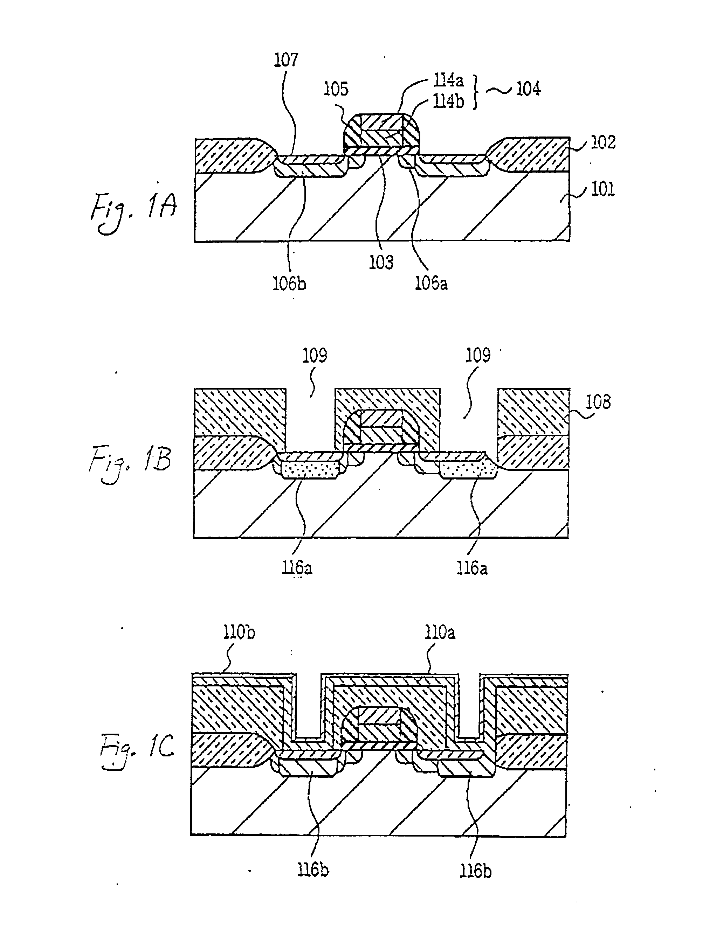

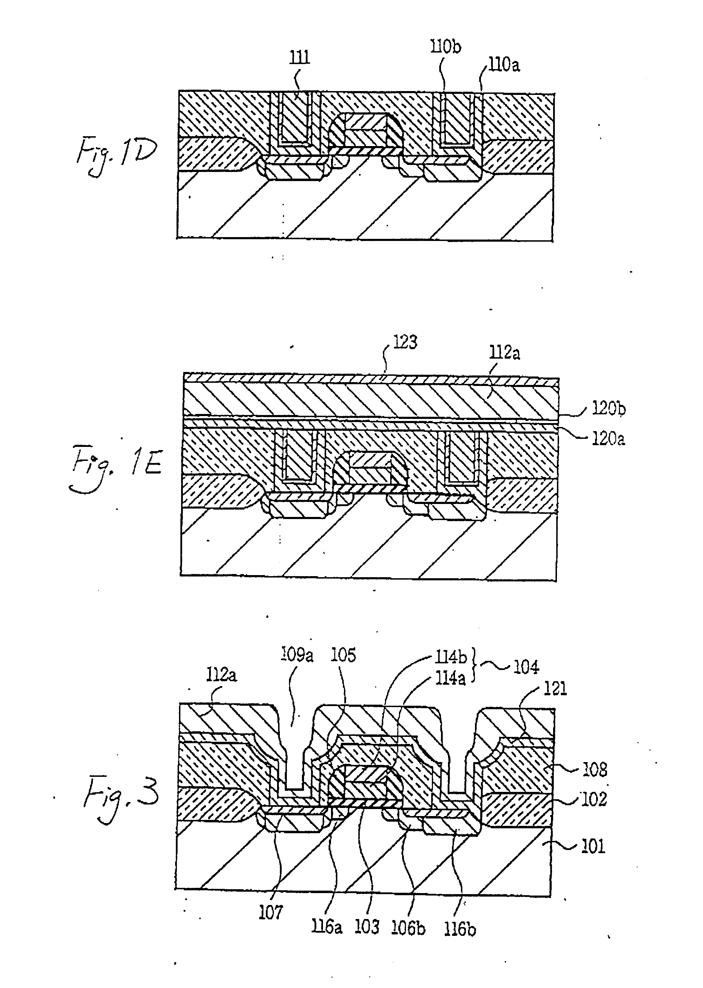

Referring now to Fig. 1, the description will be made in detail on first embodiment of the present invention.

First, an LDD MOS transistor having a metal silicide layer is formed as shown in Fig. 1A. More specifically, a field oxide film 102 having a thickness of 300 to 600 nm is selectively formed on an n-type silicon substrate 101 to define an active region by the selective oxidation technique which is well-known in the art. If desired, a guard ring or a channel stopper region may be formed just under the field oxide film 102. A gate insulating film 103 made of silicon oxide is then formed on the active region by the thermal oxidation. Formed on the gate insulating film 103 is a gate electrode 104 consisting of a polysilicon film 114a of 50 to 200 nm thick and a tungsten silicide film 114b of 50 to 200 nm thick. By using the gate electrode 104 and the field oxide film 102 as a mask, boron ions are implanted with an energy of about 10 to 30 keV and a dose-amount of 10¹²to 10¹³cm-²toform a lightly-doped regions 106a. A silicon oxide film of 100 to 300 nm is thereafter formed by the CVD technique and then etched back anisotropically to form side wall spacers 105 on the sides of the gate electrode 104. The gate oxide film 103 is selectively removed to expose parts of the region 106a. Thereafter BF₂ ions are implanted with an energy of about 30 to 70 keV and a dose-amount of about 10¹⁵ cm-² by using the field oxide film 102, the gate electrode 104 and the spacers 105 as a mask. Highly-doped regions 106b are thereby formed. A titanium film (not shown) of 30 to 80 nm thickness is then formed by the sputtering technique over the entire surface, followed by a heat treatment at 600 to 800°C to form titanium silicide layers 107 at the surface of each region 106b. The unreacted titanium film is then removed. Thus, the LDD MOS transistor is formed with the silicide layer on the source and drain regions thereof.

Turning to Fig. 1 B, an interlayer insulating film 108 is then formed over the entire surface. The film 108 is made of silicon oxide. If desired, the film 108 may be composed of a plurality of insulating film in the same way as the prior art. Subsequently, the film 108 is selectively removed to form contact holes 109 each exposing a part of the associated silicide layer 107. At this time, the alingment margin is reduced, the right-hand contact hole 109 exposes a part of the PN junction between the region 106b and the substrate 101. Boron ions are therefore implanted through the contact holes 109 and the silicide layers 107 into the respective parts of the regions 106b and the substrate 101. Thus, boron-implanted regions 116a are formed in a manner self-aligned with the contact holes 109.

Referring to Fig. 1 C, a titanium film 110a of 20 to 100 nm thick is thereafter deposited over the entire surface. A heat treatment is then carried out in a nitrogen gas atmosphere to activate the boron ions contained in the regions 116a. Highly-doped p-type regions 116b are thereby formed. In addition, the surface portion of the titanium film 110a is nitrified to form a titanium nitride film 110b. In this heat treatment, the high-temperature and short annealing using heat source such as halogen lamps is preferred. If desired, a titanium nitride film is deposited on the titanium film 110a by the sputtering method, followed by the thermal activation treatment in an inert atmosphere such as an argon gas.

Subsequently, a blanket tungsten film is deposited over the whole surface by the CVD method, followed by etching-back to leave the tungsten film 111, the titanium nitride film 110b and the titanium film 110a only in the contact holes 109, as shown in Fig. 1 D. Alternatively, only the tungsten film may be selectively etched back to fill the contact holes 109. In this case, the titanium nitride film 110b and the titanium film 110a are etched off in the later step. If desired, further, a selective deposition of tungsten may be also employed.

Subsequently, a titanium film 120a, a titanium nitride film 120b, an aluminiurn-silicon-copper alloy film 112a and a reflection-preventing film 123 such as TiN or silicon are formed in that order, as shown in Fig. 1 E. A patterning by photolithography is carried out to form desired wiring layers (not shown).

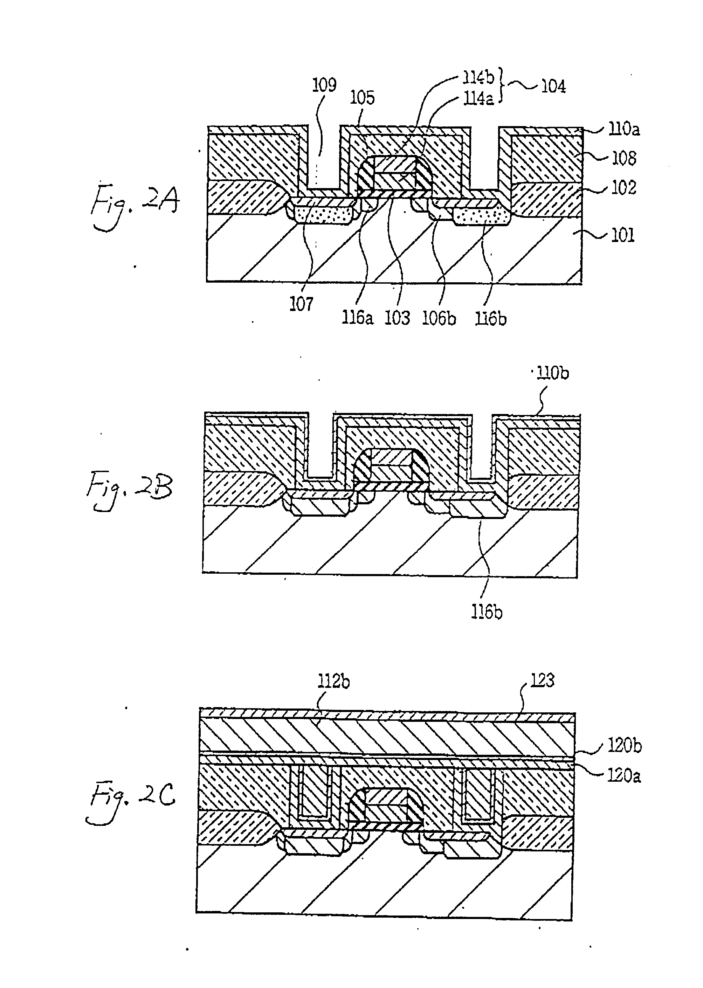

In the above embodiment, the boron-implanted regions 116a are formed before forming the titanium layer 110a. However, the regions 116a can be formed after the formation of the layer 110a, as shown in Fig. 2 as a second embodiment of the present invention. Specifically, after forming the contact holes 109 in the insulating film 108, a titanium film 110a as a refractory metal is deposited over the whole surface, followed by ion implantation through the titanium film 110a and the hole 109 to form the boron-ion regions 116a, as shown in Fig. 2A.

The annealing process is thereafter performed in a nitrogen gas atmosphere to thereby form the highly-doped regions 116b as well as the titanium nitride film 110b, as shown in Fig. 2B.

The next step as shown in Fig. 2C is the same as the step as shown in Fig. 1 E and thus the description thereof will be omitted.

Referring to Fig. 3 indicative of a cross section of the semiconductor device according to a third embodiment of the present invention proceeds, an interlayer insulating film 108 is formed over the entire surface in a manner as described with reference to Fig. 1. Subsequently contact holes 109a with the upper portion assuming inverted-cone shape are opened by combining a wet-etching and a dry-etching, which allows to omit the step offilling the contact holes with a conducting film. After forming boron-ion implanted regions in the same way as in the first embodiment, a titanium-tungsten film 121 as a refractory metal is deposited over the whole surface by the sputtering technique, followed by thermal activation treatment in an inert gas to form p+ regions 116b. The titanium-tungsten film 121 serving as a barrier metal layer, similarly to the barrier metal layers 110a and 110b shown in the first and second embodiments. Over the whole surface an aluminium-silicon-copper alloy film 112a is formed. Following this, alloy film 112 and titanium-tungsten film 121 are patterned to form wiring layers (not shown).

Although the above description is made on the p-channel MOS transistor, the present invention is applicable to other devices such as n-channel MOS transistors or a CMOS transistors. That is, the present invention is not limited to the above embodiment but may be modified and changed without departing from the scope and spirit of the invention.

## Claims

1. A method of producing a semiconductor device comprising the steps of selectively forming an element region of one conductivity type in a semiconductor layer of an opposite conductivity type, forming a metal silicide layer on at least one part of said element region in isolation from said semiconductor layer, forming an insulating film to cover said element region, said metal silicide layer and said semiconductor layer, forming a contact hole to expose a portion including at least one partofsaid metal silicide layer, doping impurity ions representative of said one conductivity type through said contact hole and said metal si icide layer to form impurity-doped region, forming a metal layer in contact with said portion, and annealing in an atmosphere free from oxygen while covering said portion with said metal layer to activate said impurity ions contained in said impurity-doped region.

2. The method as claimed in claim 1, wherein said metal layer comprises a refractory metal.

3. The method as claimed in claim 2, wherein said step of doping impurity ions is carried out before forming said metal layer.

4. The method as claimed in claim 3, wherein said step of annealing is carried out in a nitrogen gas.

5. The method as claimed in claim 3, wherein said step of annealing is carried out in an inert gas.

6. The method as claimed in claim 2, wherein said step of doping impurity ions is carried out after forming said metal layer.

7. The method as claimed in claim 6, wherein said step of annealing is carried out in a nitrogen gas.

8. The method as claimed in claim 6, wherein said step of annealing is carried out in an inert gas.

9. A method of producing a semiconductor device comprising the steps of forming a MOS transistor having source and drain regions in a semiconductor substrate, forming metal silicide layers on respective parts of said source and drain regions, covering said MOS transistor with an insulating film, forming in said insulating film contact holes each exposing a part of an associated one of said metal silicide layers, implanting impurity ions indicative of the same conductivity type as said source and drain regions through said contact holes and said metal silicide layers to form impurity-ion-implanted regions in contact with said source and drain regions, respectively, forming a refractory metal in each of said contact holes, and annealing in an atmosphere free from oxygen to activate the impurity ions contained in said impurity-ion-implanted regions after forming said refractory metal.

10. The method as claimed in claim 9, wherein said step of implanting impurity ions is carried out before forming said refractory metal.

11. The method as claimed in claim 9, wherein said step of implanting impurity ions is carried out after forming said afractory metal.
